# EUROPÄISCHE PATENTANMELDUNG

(11) **EP 1 107 034 A2**
(43) Veröffentlichungstag der Anmeldung: **13.06.2001**
(21) Anmeldenummer: 00125619.7
(22) Anmeldetag: 23.11.2000
(51) Int. Cl.: G02B 7/02, G03F 7/20

(54) **Vorrichtung und Verfahren zur deformationsarmen Lagerung des optischen Elementes**

(30) Priorität: 10.12.1999 DE 19959741
(71) Anmelder: Carl Zeiss, 89518 Heidenheim (Brenz) (DE)
(72) Erfinder: Ebert, Michael, 76275 Ettlingen (DE); Marianek, Frank, 73447 Oberkochen (DE); Sorg, Franz, 73433 Aalen (DE); Osterried, Karlfrid, Dr., 73431 Aalen (DE); Trunz, Michael, 73479 Pfahlheim (DE); Kasparek, Markus, 77704 Oberkirch (DE)
(74) Vertreter: Lorenz, Werner, Dr.-Ing.

(57) **Zusammenfassung**

Eine Vorrichtung zur deformationsarmen Lagerung eines optischen Elementes (2), insbesondere einer Abschlußplatte eines Objektives in einer Projektionsbelichtungsanlage für Halbleiterbauelemente, ist mit einer Fassung (1) versehen, wobei das optische Element (2) mit der Fassung (1) wenigstens teilweise über eine Klebeschicht verbunden ist, die sich zwischen den aneinandergrenzenden Umfangswänden (4,5) von Fassung (1) und optischem Element (2) befindet. Die Fassung (1) ist mit wenigstens drei über den Umfang verteilte Auflagefüßchen (3) versehen, auf denen das optische Element (2) aufliegt. Die Klebeschicht befindet sich in einem Ringspalt (6) zwischen den aneinandergrenzenden Umfangswänden (4,5) von Fassung (1) und optischem Element (2) über wenigstens einen Teilbereich davon.

## Beschreibung

Die Erfindung betrifft eine Vorrichtung zur deformationsarmen Lagerung eines optischen Elementes, insbesondere einer Abschlußplatte eines Objektives in einer Projektionsbelichtungsanlage für Halbleiterbauelemente, nach der im Oberbegriff von Anspruch 1 näher definierten Art. Die Erfindung betrifft auch ein Verfahren zur deformationsarmen Lagerung des optischen Elementes.

Eine gattungsgemäße Vorrichtung ist in der DE 41 13 956 C2 beschrieben. Danach ist es bereits bekannt, eine Klebeschicht ausschließlich im Umfangsbereich zwischen einem optischen Element und einer dieses umgebenden Fassung vorzusehen. Weiterhin ist die Fassung mit einer Rille versehen, durch die verhindert wird, daß z.B. durch Kapillarwirkungen Klebstoff über die eigentliche Klebstoff-Kontaktfläche hinauswandern kann. Zusätzlich zu der Verklebung, welche sich über den ganzen Umfangsbereich erstreckt, ist das optische Element durch eine Art Vorschraubring in axialer Richtung gehalten bzw. eingeklemmt. Aufgabe der vorbekannten Vorrichtung ist es, eine definierte Klebefuge zu erzeugen, die die thermischen Dehnungsdifferenzen zwischen Fassung und optischem Element aufnehmen kann.

Bekannte Abschlußplatten in Objektiven einer Projektionsbelichtungsanlage besitzen eine L-förmige rotationssymmetrische Klebefläche. Auf diese Klebefläche wird Klebekitt aufgetragen. Nach dem Aushärten wird die Klebefläche zu einem L-förmigen Klebekittbett ausgedreht, damit eine gleichmäßige Auflagefläche entsteht. Auf diese Auflagefläche wird wiederum Klebekitt aufgetragen und anschließend wird die Abschlußplatte eingedrückt. Der Klebekitt verhärtet abschließend und die Überreste werden entfernt.

Nachteilig bei diesem aus der Praxis bekannten Klebeverfahren ist jedoch, daß durch die L-förmige Klebestelle über Momente eine Verspannung in die Abschlußplatte induziert wird. Darüber hinaus ist dieses Herstellverfahren mit einem erheblichen Aufwand verbunden, denn nach der ersten Auftragung einer Klebeschicht, durch die garantiert werden soll, daß über den Umfang eine Egalisierung auftritt und damit vermieden wird, daß die Abschlußplatte noch irgendwo das Metall der Fassung berührt, muß anschließend gewartet werden, bis die Klebeschicht aushärtet, die Vorrichtung muß in ein Werkzeug gespannt und die Auflagefläche gleichmäßig ausgedreht werden. Erst dann wird die eigentliche Klebeschicht auf die L-förmige Klebefläche aufgebracht.

Bei der Aufbringung der Klebeschicht wurde nun auch festgestellt, daß sich zeitlich verändernde Verspannungen zwischen dem optischen Element, insbesondere einer Abschlußplatte eines Objektives für eine Projektionsbelichtungsanlage, ergeben. Die Verspannungen ändern sich dabei während der Aushärtung der Klebeschicht und auch dann, wenn die Abschlußplatte gereinigt wird.

Der vorliegenden Erfindung liegt die Aufgabe zugrunde, eine Vorrichtung der eingangs erwähnten Art zu schaffen, bei der das optische Element wenigstens weitgehend deformationsfrei bzw. unter Vermeidung von Verspannungen in der Fassung gelagert werden kann, insbesondere eine Lagerung zu schaffen, durch die sich zeitlich verändernde Verspannungen wenigstens weitgehend eliminiert werden.

Erfindungsgemäß wird diese Aufgabe durch die im kennzeichnenden Teil von Anspruch 1 genannten Merkmale gelöst. Ein erfindungsgemäßes Verfahren zur deformationsarmen Lagerung ist in Anspruch 7 angegeben.

Erfindungsgemäß wird durch ein Kleben nur an der Mantelfläche bzw. den aneinandergrenzenden Umfangswänden von Fassung und optischem Element eine wenigstens weitgehende Freiheit von Verspannungen erreicht. Um ein Durchdrücken des optischen Elementes zu verhindern und um eine genauere Positionierung des optischen Elementes zu erreichen, werden an der Fassung wenigstens drei Auflagefüßchen angebracht, auf denen die Platte direkt aufliegt. Auf diese Weise wird eine definierte Dreipunktauflage erreicht.

In vorteilhafter Weise kann man an die Umfangswand der Fassung im Bereich der Auflagefüßchen Kleberstege aufbringen, durch die eine Zentrierung des optischen Elementes vor dem Aufbringen der Klebeschicht im Umfangsbereich erreicht wird.

Wenn anschließend nach dem Aushärten und Ausdrehen des von den Klebestegen gebildeten Kittbettes die Klebeschicht über den gesamten Umfangsbereich des zwischen den aneinandergrenzenden Umfangswänden von Fassung und optischem Element gebildeten Ringspaltes eingebracht wird, dann wird gleichzeitig auch eine Abdichtung zwischen der Fassung und dem optischen Element geschaffen.

In einer weiteren, sehr vorteilhaften Ausgestaltung der Erfindung kann vorgesehen sein, daß die Auflagefüßchen mit Kleberaufnahmetaschen versehen sind.

Die Kleberaufnahmetaschen bilden einen Spalt, wozu sie vorzugsweise durch radiale Einschnitte in der Fassung gebildet sind, zwischen der inneren Umfangswand der Fassung und den Auflagefüßchen. In diesen Spalt kann Kleber von den Kleberstegen hineinlaufen. Auf diese Weise wird ein Ausweichraum für zuviel eingebrachten Kleber geschaffen.

Nachfolgend ist ein Ausführungsbeispiel der Erfindung anhand der Zeichnung prinzipmäßig beschrieben.

Es zeigt:
- Figur 1: eine perspektivische Darstellung einer erfindungsgemäßen Fassung mit Auflagefüßchen für ein optisches Element;
- Figur 2: einen Teilschnitt in vergrößerter Darstellung durch eine Fassung und eine Abschlußplatte als optischem Element im Bereich der Auflagefüßchen;
- Figur 3: ausschnittsweise eine Fassung im Bereich eines Auflagefüßchen; und
- Figur 4: ausschnittsweise einen Teilschnitt durch eine Fassung und ein optisches Element in einem Bereich ohne Auflagefüßchen.

Eine Fassung 1, die grundsätzlich von bekannter Bauart ist, und die zur Lagerung eines optischen Elementes, z.B. einer Abschlußplatte 2 eines Objektives für Projektionsbelichtungsanlagen für Halbleiterbauelemente dienen kann, ist im inneren Umfangsbereich mit drei gleichmäßig über den Umfang verteilt angeordneten Auflagefüßchen 3 versehen.

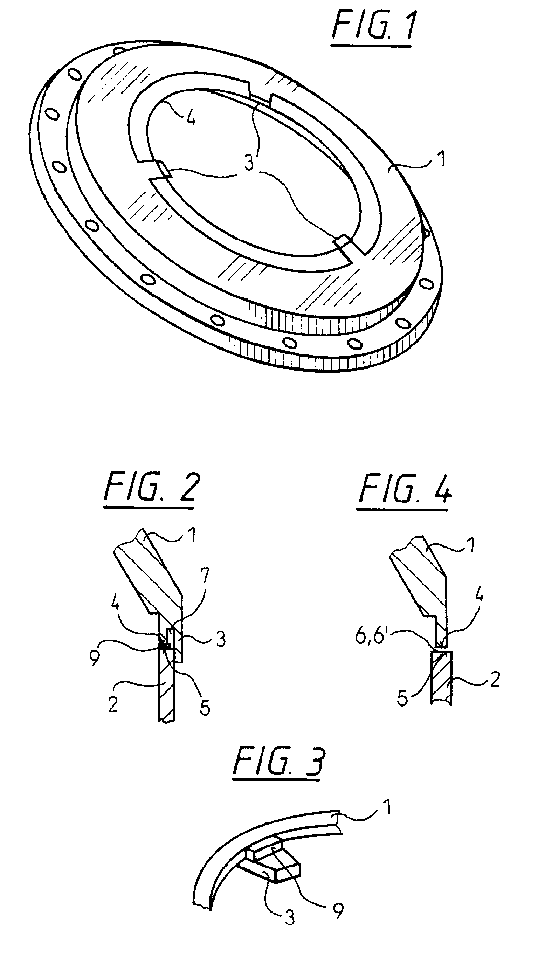

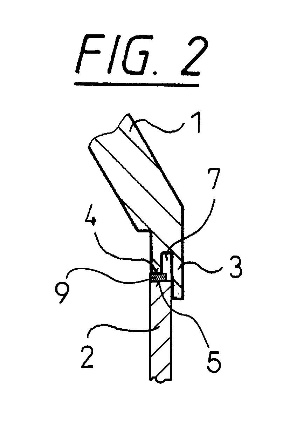

Die Auflagefüßchen 3 sind mit der Fassung 1 einstückig und ragen über die innere Umfangswand 4 der Fassung 1 hinaus. Die Fassung 1 kann - wie aus den Figuren 2 und 4 ersichtlich ist - im inneren Umfangsbereich eine Querschnittsreduzierung aufweisen. Die Durchmesser der inneren Umfangswand 4 der Fassung 1 und der Umfangswand 5 des optischen Elementes, nämlich der Abschlußplatte 2, sind so zueinander gewählt, daß dazwischen ein Ringspalt 6 verbleibt.

Aus der Fig. 2 ist ersichtlich, daß die Auflagefüßchen 3 mit Kleberaufnahmetaschen 7 versehen sind. Die Kleberaufnahmetaschen 7 werden dadurch gebildet, daß im Bereich der Auflagefüßchen 3 die Fassung 1 in ihrer Umfangswand 4 mit einem radialen Einschnitt versehen ist.

Die Lagerung der Abschlußplatte 2 in der Fassung 1 wird auf folgende Weise durchgeführt:

Im Bereich der Auflagefüßchen 3 werden an die Umfangswand 4 der Fassung 1 (siehe Fig. 2 und 3) radiale Kleberstege 9 aufgebracht. Nach dem Aushärten der Klebestege 9 werden die auf diese Weise gebildeten drei Klebekittbette ausgedreht, so daß dadurch ein definierter Ringspalt 6 entsteht. Die drei Auflagefüßchen 3 werden dabei metallisch blankgedreht, wobei die Abschlußplatte auf den blanken Füßen aufliegt. Dadurch wird eine Zentrierung für die Abschlußplatte 2 erreicht. In das auf diese Weise erzeugte Klebekittbett wird deshalb die Abschlußplatte 2 gelegt und entsprechend zentriert. Anschließend wird in den Ringspalt 6 zwischen der Umfangswand 4 der Fassung 1 und der Umfangswand 5 der Abschlußplatte 2 umlaufend eine Kittkleberschicht 6' aufgebracht, womit dann gleichzeitig auch eine Abdichtung der Fassung 1 und der Abschlußplatte 2 hergestellt wird. Die Auflagefüßchen 3 werden praktisch nur zur axialen Zentrierung der Abschlußplatte 2 verwendet. Die eigentliche Verbindung zwischen der Fassung 1 und der Abschlußplatte 2 erfolgt am Umfang der Abschlußplatte 2 bzw. deren Mantelfläche durch die Kleberschicht 6' in dem Ringspalt 6.

Durch die Kleberaufnahmetaschen 7 in Form des Spaltes in der Fassung 1 wird verhindert, daß beim Aufbringen der Kleberstege 9 an die Auflageflächen 4 durch Kapillarwirkung der Kleber an irgendeiner Stelle ungewollt ausfließt. Im idealen Fall sollten diese Taschen allerdings kleberfrei sein.

Durch die Auflagefüßchen 3 wird in z-Richtung (Berührung Metall/Glas) eine definierte Auflagefläche geschaffen. Durch die erfindungsgemäße Lagerung werden deutlich reduzierte Verspannungen der Abschlußplatte 2 erreicht, derart, daß durch einen gleichmäßigen Ringspalt 6 die durch Kleberschrumpf entstehenden Spannungen eine homogene Spannungsverteilung am Umfang ergeben. Dadurch, daß sich die Klebung auf der Höhe der neutralen Faser der Abschlußplatte 2 befindet, werden Momente auf die Abschlußplatte 2 durch Klebeschrumpf vermieden.

## Patentansprüche

1. Vorrichtung zur deformationsarmen Lagerung eines optischen Elementes, insbesondere einer Abschlußplatte eines Objektives in einer Projektionsanlage für Halbleiterbauelemente in einer Fassung, wobei das optische Element mit der Fassung wenigstens teilweise über eine Klebeschicht verbunden ist, die sich zwischen den aneinandergrenzenden Umfangswänden von Fassung und optischem Element befindet, dadurch gekennzeichnet, daß die Fassung (1) mit wenigstens drei über den Umfang verteilten Auflagefüßchen (3) versehen ist, auf denen das optische Element (2) aufliegt, und daß sich die Klebeschicht in einem Ringspalt (6) zwischen den aneinandergrenzenden Umfangswänden von Fassung (1) und optischem Element (2) wenigstens in Teilbereichen daran befindet.

2. Vorrichtung nach Anspruch 1, dadurch gekennzeichnet, daß an die Umfangswand (4) der Fassung (1) im Bereich der Auflagefüßchen (3) Kleberstege (9) zur Zentrierung des optischen Elementes (2) aufgebracht sind.

3. Vorrichtung nach Anspruch 2, dadurch gekennzeichnet, daß die Kleberstege (9) im Bereich der neutralen Faser des optischen Elements (2) angeordnet sind.

4. Vorrichtung nach Anspruch 1, 2 oder 3, dadurch gekennzeichnet, daß sich die Klebeschicht (6') über den gesamten Umfang des Ringspaltes (6) erstreckt.

5. Vorrichtung nach einem der Ansprüche 1 bis 4, dadurch gekennzeichnet, daß die Auflagefüßchen (3) mit Kleberaufnahmetaschen (7) versehen sind.

6. Vorrichtung nach Anspruch 5, dadurch gekennzeichnet, daß die Auflagefüßchen (3) mit der Fassung (1) einstückig ausgebildet sind und daß die Kleberaufnahmetaschen (7) durch radiale Einschnitte in der Fassung (1) gebildet sind.

7. Verfahren zur deformationsarmen Lagerung eines optischen Elementes, insbesondere einer Abschlußplatte eines Objektives in einer Projektionsbelichtungsanlage für Halbleiterbauelemente, in einer Fassung, wobei zwischen den aneinandergrenzenden Umfangswänden von Fassung und optischem Element wenigstens teilweise eine Klebeschicht eingebracht wird, dadurch gekennzeichnet, daß die Auflagefüßchen (3) mit der Fassung (1) einstückig ausgebildet sind und daß nach Aufbringung von Kleberstegen (9) das optische Element (2) auf wenigstens drei Auflagefüßchen (3) aufgelegt und über die Klebestege zentriert wird, und daß nach Zentrierung des optischen Elementes (2) in einen Ringspalt (6) zwischen die aneinandergrenzenden Umfangswände von Fassung (1) und optischem Element (2) wenigstens über Teilbereiche eine Klebeschicht (6') aufgebracht wird.

8. Verfahren nach Anspruch 7, dadurch gekennzeichnet, daß die Kleberstege (9) an der Umfangswand (4) der Fassung im Bereich der Auflagefüßchen (3) aufgebracht werden.

9. Verfahren nach Anspruch 7 oder 8, dadurch gekennzeichnet, daß die Klebeschicht (6') über den gesamten Umfang des Ringspaltes (6) zwischen Fassung (1) und optischem Element (2) aufgebracht wird und eine Abdichtung zwischen der Fassung (1) und dem optischen Element (2) bildet.

10. Verfahren nach einem der Ansprüche 7 bis 8, dadurch gekennzeichnet, daß die Kleberstege (9) im Bereich der neutralen Faser des optischen Elements (2) an der Umfangswand (4) der Fassung (1) aufgebracht werden.
